# EUROPÄISCHE PATENTANMELDUNG

(11) **EP 2 605 225 A1**
(43) Veröffentlichungstag der Anmeldung: **19.06.2013**
(21) Anmeldenummer: 12194511.7
(22) Anmeldetag: 28.11.2012
(51) Int. Cl.: G08B 13/24, G01R 11/24, G01D 4/02, G01R 22/06

(54) **Vorrichtung zur Erkennung von Manipulationen an Verbrauchserfassungsgeräten**

(30) Priorität: 13.12.2011 DE 202011108935 U
(71) Anmelder: Techem Energy Services GmbH, 65760 Eschborn (DE)
(72) Erfinder: Reus, Jürgen, 63579 Freigericht (DE); Müller, Peter, 63741 Aschaffenburg (DE)
(74) Vertreter: KEIL & SCHAAFHAUSEN Patentanwälte

(57) **Zusammenfassung**

Die Erfindung betrifft eine Vorrichtung zur Erkennung von Manipulationen an einem Verbrauchserfassungsgerät mit einer Messeinrichtung (1) und wenigstens einem an dem Verbrauchserfassungsgerät angeordneten Kommunikationsmodul (2) zur Verarbeitung der von der Messeinrichtung (1) gemessenen Verbrauchsdaten, wobei die Vorrichtung einen magnetischen Geber (4) zur Erzeugung eines Magnetfeldes, einen Sensor (5) zur Erfassung des vom magnetischen Geber (4) erzeugten Magnetfeldes und eine Auswerteeinheit zur Verarbeitung der von dem Sensor (4) erzeugten Signale und zur Anzeige einer Relativbewegung zwischen Kommunikationsmodul (2) und der Messeinrichtung (1) aufweist. Der Sensor (5) ist derart ausgebildet, dass er die Feldrichtung und Feldstärke des Magnetfeldes überwacht.

## Beschreibung

Die vorliegende Erfindung betrifft eine Vorrichtung zur Erkennung von Manipulationen an einem Verbrauchserfassungsgerät mit einer Messeinrichtung und wenigstens einem an dem Verbrauchserfassungsgerät angeordneten Kommunikationsmodul zur Verarbeitung der von der Messeinrichtung gemessenen Verbrauchsdaten, wobei die Vorrichtung einen magnetischen Geber zur Erzeugung eines Magnetfeldes, einen Sensor zur Erfassung des von dem magnetischen Geber erzeugten Magnetfeldes und eine Auswerteeinheit zur Verarbeitung der von dem Sensor erzeugten Signale und zur Anzeige einer Relativbewegung zwischen Kommunikationsmodul und der Messeinrichtung aufweist. Die Erfindung betrifft auch ein entsprechendes Verbrauchserfassungsgerät.

Je nach Art des Mediums kommen zur Ermittlung mediumbezogener Informationswerte, üblicherweise Verbrauchswerte, unterschiedliche Verbrauchserfassungsgeräte bzw. -messgeräte zum Einsatz. Im Falle eines flüssigen Mediums, wie beispielsweise Wasser, handelt es sich um Wasserzähler. Andere Zähler dienen der Erfassung des Strom-, Gas, oder Wärmeverbrauchs. Mit der Messeinrichtung wird der jeweilige Informationswert, zum Beispiel ein Verbrauchswert, ermittelt oder errechnet. Dabei kann auf den Zähler ein separates Kommunikationsmodul aufgesetzt werden, wie es in der DE 10 2005 051 159 A1 beschrieben ist, mit dem sich die Verbrauchswerte insbesondere drahtlos übermitteln lassen. Dieses Kommunikationsmodul ist vorzugsweise leitungslos mit der Messeinrichtung verbunden. Die Übertragung erfolgt durch kapazitive Übertragungsmittel. Diese sind jeweils unmittelbar hinter der jeweiligen Gehäusewand angeordnet und in der Montagestellung einander direkt gegenüberliegend positioniert.

Bei Wasserzähler werden die Umdrehungen eines Flügelrades beispielsweise über eine kapazitiv abgetastete Modulatorscheibe ermittelt. Dabei bildet die eine elektrisch leitende Teilfläche aufweisende Modulatorscheibe den einen Teil einer Kommunikationsschnittstelle und ist unmittelbar gehäusewandseitig angeordnet. Im Kommunikationsmodul ist der zweite Teil der kapazitiven Kommunikationsschnittstelle angeordnet, über welchen die Umdrehungen der zählerseitigen Modulatorscheibe erfasst werden. Aus der Anzahl dieser Umdrehungen ermittelt das Kommunikationsmodul bzw. dessen Steuerungseinrichtung das durchfließende Wasservolumen und überträgt das Ermittlungsergebnis. Die Kommunikation erfolgt beispielsweise über ISM-Funk, über einen M-Bus oder ein anderes im Stand der Technik bekanntes Kommunikationssystem.

Technologiebedingt ergibt sich z.B. bei der kapazitiven Kommunikationsschnittstelle, dass das Kommunikationsmodul in seiner Position unverändert zur Messeinrichtung bleiben muss. Schon eine geringfügige Veränderung der Position, ausgelöst z.B. durch ein Abheben oder Verschieben des Kommunikationsmoduls um wenige Millimeter, kann die Übertragung stören. Häufig wird durch Nichtberechtigte versucht, die Verbrauchsmesseinrichtung zu manipulieren und das Messergebnis zu beeinflussen. Daher ist es bei allen Arten von Verbrauchsmessvorrichtungen, seien es Strom-, Gas, Wärmezähler oder Heizkostenverteiler, notwendig, die Geräte gegen unerlaubte Eingriffe Dritter zu schützen. Wichtig ist vor allem, dass eine unberechtigte Demontage des Kommunikationsmoduls unterbunden wird. Dies ist möglich durch die Anwendung einer Vorrichtung, die derartige Manipulationsversuche erkennt und meldet. Dabei zeigt sich, dass auch eine solche Erkennungsvorrichtung selbst gegen Beeinflussungsversuche von außen zuverlässig geschützt sein muss. Beispielsweise kann das Anlegen eines beliebig gerichteten stationären Magnetfeldes bei einem kostengünstigen Magnetschalter die Demontageerkennung außer Kraft setzen.

In der EP 1 571 428 A1 wird ein Fernablesemodul beschrieben, welches über eine Vorrichtung zur einfachen Fixierung des Moduls auf der Messeinrichtung verfügt. Die Messdaten werden durch Abtastung der Zahlen eines Rollenzählwerks mit einem optischem Sensor bzw. über eine magnetische Kommunikationsschnittstelle an das Kommunikationsmodul übertragen. Eine Verschiebung oder ein Abheben des Moduls führt zu einer Störung der Kommunikation.

In der DE 10 2007 061 315 A1 wird eine einfache mechanische Verbindung vorgeschlagen, die durch Demontage zerstört wird und auf diese Weise einen Manipulationsversuch anzeigt. Bei Kommunikationsmodulen, insbesondere bei solchen, die ihre Daten über eine Funkschnittstelle übertragen, wird die Zerstörung dieser mechanischen Demontageerkennung nicht unmittelbar erkannt, da keine Überprüfung der Unversehrtheit durch einen Ableser erfolgt. Stattdessen werden die Daten ohne Zutritt zur Messvorrichtung mittels Fernübertragung übermittelt. Bei mechanischen Demontageerkennungsvorrichtungen im Zusammenspiel mit einer Funkübertragung der Messdaten stellt sich insbesondere bei Wasserzählern das Problem, dass ein Manipulationsversuch nicht rechtzeitig erkannt wird, so dass dies zu einer fehlerhaften Verbrauchsabrechnung führen kann.

In der EP 1 857 989 A1 wird ein Sensor zur Demontageerkennung in Form eines Abstands- oder Lichtsensors vorgeschlagen. Dieser erkennt eine Veränderung des Abstands zwischen einer Montagegrundplatte und einem abnehmbaren Kommunikationsmodul. Alternativ wird vorgeschlagen, als Sensoren Demontagekontakte beispielsweise in Form mechanischer Tastschalter mit Neigungssensoren in Form von Quecksilberschaltern oder magnetischen Schaltern vorzusehen. Insbesondere bei einem Wasserzähler besteht aber die Problematik der Gehäuseausführung, da dieses häufig im Nassbereich eingesetzt wird. Dort sind mechanische Schalter außerhalb des Gehäuses ungeeignet, da diese z.B. durch Spritzwasser unbrauchbar werden.

Aus der DE 10 2004 052 993 A1 ist eine Vorrichtung zur Erkennung von Gehäusemanipulationen an einem Verbrauchszähler bekannt, bei der ein erstes Gehäuseteil mit einer Auswerteelektronik mit einem zweiten Gehäuseteil verbunden wird, wobei das zweite Gehäuseteil gegen unberechtigtes Entfernen vom ersten Gehäuseteil gesichert ist. Die Manipulationserkennung sieht in dem ersten Gehäuseteil einen elektrischen Schwingkreis vor, dessen Spule durch ein im zweiten Gehäuseteil befindliches metallisches Material bei einer Änderung des Abstandes zwischen den Gehäuseteilen ein Signal erzeugt und so einen Manipulationsversuch meldet. Diese Lösung weist zwar eine Abstandsüberwachung auf, ist aber dennoch manipulationsgefährdet. Wird die Orientierung der Gehäuseteile zueinander verändert, ohne den Abstand zwischen den Elementen zu vergrößern oder zu verkleinern, wird die Manipulation nicht erkannt. Auch Fremdmagnetfelder, welche beispielsweise durch einen über das Gehäuse bewegten Dauermagneten erzeugt werden, führen zur Beeinflussung des Schwingkreises und es kommt dadurch zu Fehlalarmen.

Der Erfindung liegt daher die Aufgabe zugrunde, eine einfache, kostengünstige und zuverlässige Einrichtung anzugeben, die das unerlaubte Demontieren des Zusatzmoduls von einem Zähler, insbesondere einem Wasserzähler, erkennt und die selbst durch Beeinflussungsversuche von außen zuverlässig geschützt ist.

Diese Aufgabe wird bei einer Vorrichtung mit den Merkmalen des Anspruchs 1 erfindungsgemäß im Wesentlichen dadurch gelöst, dass der Sensor derart ausgebildet ist, dass er die Feldrichtung und Feldstärke des Magnetfeldes überwacht.

Entsprechend einer gewählten Konfiguration, d.h der Anordnung von magnetischem Geber zu Sensor, wird durch den magnetischen Geber, welcher z.B. ein Permanentmagnet in Form eines Stabmagneten sein kann, ein in Richtung und Feldstärke genau definiertes und diesbezüglich auswertbares Magnetfeld erzeugt. Der Sensor kann z.B. als magnetoresistiver oder als Hall-Sensor konfiguriert sein und ist hinsichtlich seiner Position auf die Größe des Magnetfeldes abgestimmt bzw. ausgewählt. Er überwacht das vom magnetischen Geber erzeugte Magnetfeld in Feldrichtung und Feldstärke, wobei die Flussdichte gemessen wird. Anders als bei bekannten Lösungen, wie z.B. in der DE 10 2004 052 993 A1, findet hier auch eine Bewertung der Feldrichtung bzw. der gewählten Polarität des magnetischen Gebers statt. Das führt dazu, dass nicht nur eine Veränderung des Abstands zwischen dem Kommunikationsmodul und der Messeinrichtung überwacht wird, sondern auch die Veränderung der Orientierung dieser beiden Bauteile zueinander. Dies erhöht die Sicherheit gegenüber Manipulationsversuchen deutlich.

Das vorteilhafte der erfindungsgemäßen Erkennungsvorrichtung zeigt sich insbesondere dann, wenn versucht wird, das Kommunikationsmodul zu demontieren. Durch den Sensor können bereits geringe Abweichungen beispielsweise von der erforderlichen Richtung des Magnetfelds erkannt werden. Somit ist auch eine Beeinflussung der Demontageerkennung weitgehend ausgeschlossen. Insbesondere aber sind die Anordnung und die gewählte Polarität des magnetischen Gebers von außen nicht erkennbar. Daher kann ein nichtberechtigter Dritter nicht erkennen, mit welcher Polarität ein äußeres Magnetfeld angelegt werden müsste, um ein Auslösen der Demontageerkennung zu unterbinden.

Vorzugsweise ist der Nordpol des magnetischen Gebers zum Sensor ausgerichtet, wobei die relative Winkellage des magnetischen Gebers zum Sensor -5° bis +5°, vorzugsweise etwa 0° zur Sensorachse beträgt, oder bei Platzierung außerhalb der Sensorachse 25° bis 35°, vorzugsweise etwa 30° zur Sensorachse beträgt.

Erfindungsgemäß kann die Vorrichtung derart ausgeführt sein, dass der magnetische Geber in der Messeinrichtung und der Sensor im Kommunikationsmodul verbaut sind, wobei sich auch umgekehrt der magnetische Geber im Kommunikationsmodul und der Sensor in der Messeinrichtung verbauen lassen.

Die Erfindung sieht vor, dass der magnetische Geber vielfältig ausgebildet und in der Messvorrichtung befestigt sein kann. Beispielsweise kann der Geber in dem Gehäuse der Messvorrichtung z.B. eines Wasserzählers als integrierter Blockmagnet ausgeführt sein. Möglich ist auch ein magnetischer Geber in Form eines Stabmagneten, der zudem in einer speziellen Aufnahme des jeweiligen Bauteils platziert werden kann. Diese Variante wird insbesondere dann eingesetzt, wenn der Magnet außerhalb der Sensorachse liegt.

Es besteht grundsätzlich auch die Möglichkeit, einen magnetischen Geber als Magnetfolie von vorne herein in das Gehäuse oder zu einem späteren Zeitpunkt auf das Gehäuse der Messvorrichtung aufzukleben. Diese Variante wird insbesondere dann eingesetzt, wenn der Magnet im Wesentlichen in der Sensorachse liegt.

Bei der Fertigung des Wasserzählers oder dgl. kann der magnetische Geber in einem Einzelteil des Zählers eingebracht werden. Besonders vorteilhaft ist es, als Gehäuse der Messvorrichtung teilweise einen Kunststoff mit gebundenem Magnetwerkstoff zu verwenden, was sich z.B. im Zweikomponenten-Verfahren als angespritzte Gebergeometrie realisieren lässt. Mit anderen Worten lässt sich der magnetische Geber als Teil des Gehäuses ausbilden.

Vorzugsweise ist die Auswerteeinheit derart ausgebildet, dass ein Alarm an eine Datenerfassungseinrichtung gesendet wird und/oder eine Alarmanzeige erfolgt, wenn der vom Sensor erfasste Wert des Magnetfeldes vorgegebene Schwellenwerte unterschreitet und/oder überschreitet. Stellt der Sensor kein einer ausgewählten Konfiguration entsprechend geartetes Magnetfeld fest, so wird der Zustand "Demontage" gemeldet und/oder angezeigt. Auch eine lokale Anzeige an der Messstelle ist möglich, wenn eine Anzeigevorrichtung am Messgerät und/ oder dem Kommunikationsmodul vorhanden ist.

Dadurch kann im Falle einer unberechtigten Demontage, die durch teilweises oder vollständiges Abheben oder teilweises oder vollständiges Verschieben oder Verdrehen des Kommunikationsmoduls erfolgen kann, sicher gestellt werden, dass dieser Manipulationsversuch erkannt und an eine externe Empfangseinrichtung insbesondere an mobile oder stationäre Datenerfassungssysteme gemeldet werden kann.

Die Alarmübertragung und/oder Alarmanzeige kann durch entsprechende Programmierung für eine gewisse Zeitspanne abgeschaltet werden. Dies kann beispielsweise erforderlich sein, wenn eine Serviceaktivität oder Montage durchgeführt wird. Bei einer Montage beispielsweise eines Heizkostenverteilers muss, solange das Vorderteil des Heizkostenverteilers noch nicht auf dem Rückteil montiert ist, die Demontageerkennung inaktiv sein. Auch bei der nachträglichen Montage eines Kommunikationsmoduls auf der Messeinrichtung muss die Demontageerkennung inaktiv bleiben. In beiden Fällen handelt es sich nicht um eine unzulässige Demontage.

Die Erfindung wird nachfolgend anhand eines Ausführungsbeispiels und der Zeichnung näher erläutert. Dabei bilden alle beschriebenen und/oder bildlich dargestellten Merkmale für sich oder in beliebiger Kombination den Gegenstand der Erfindung, unabhängig von ihrer Zusammenfassung in den Ansprüchen oder deren Rückbezügen.

Es zeigen:
- Fig. 1: eine perspektivische Ansicht einer Messeinrichtung und eines Kommunikationsmoduls mit der erfindungsgemäßen Vorrichtung nach einer ersten Ausführungsform;
- Fig. 2: schematisch die Ausrichtung des Magneten mit dem resultierenden Magnetfeld;
- Fig. 3: die Positionierung des Sensors im Verhältnis zum Gebermagneten in einer Seitenansicht; und
- Fig. 4: eine Platine des Kommunikationsmoduls in einer Draufsicht.

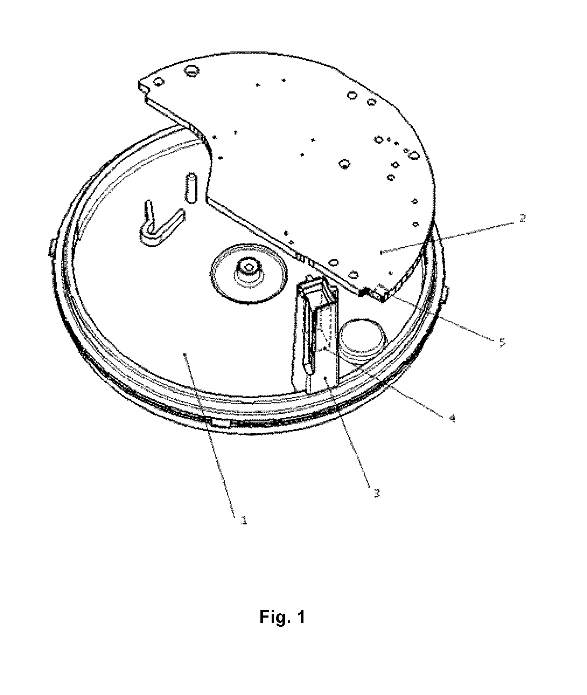

Die Figur 1 zeigt in einer perspektivischen Ansicht eine Messeinrichtung 1 eines nicht dargestellten Verbrauchserfassungsgerätes. Über der Messeinrichtung 1 ist ein Kommunikationsmodul 2 angeordnet. Im Bereich der Gehäusewand der Messeinrichtung 1 ist eine Aufnahme 3 für einen magnetischen Geber 4, welcher durch Strichlinien in seiner Einbauposition schematisch angedeutet ist, angeordnet. In der Nähe des magnetischen Gebers 4 ist auf dem Kommunikationsmodul 2 ein Sensor 5 angeordnet. Es handelt sich im dargestellten Ausführungsbeispiel um einen magnetoresistiven Sensor mit Richtungserkennung.

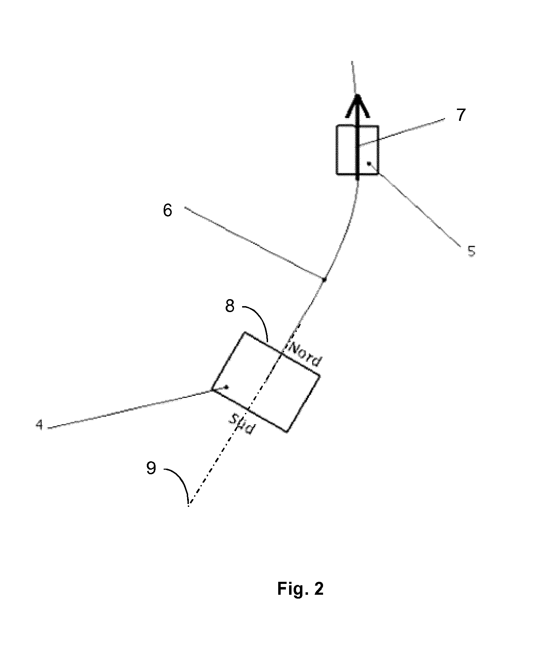

Fig. 2 zeigt, wie der magnetische Geber 4 relativ zum Sensor 5 ausgerichtet ist. Die Ausrichtung des magnetischem Gebers 4 mit seiner Polarität relativ zum Sensor 5 erzeugt ein spezielles Magnetfeld, wobei das Magnetfeld am Sensor 5 eine bestimmte Feldrichtung und Feldstärke aufweist und der Sensor 5 den für diese Konfiguration charakteristischen Wert misst. In der Draufsicht zeigt sich, dass der magnetische Geber 4 derart orientiert ist, dass sein Nordpol 8 in Richtung des Sensors 5 gerichtet ist und dass die Nordpol-Südpol-Achse 9 des magnetischen Gebers 4 gegenüber dem Sensor 5 schräg gestellt ist.

Durch diese Ausrichtung der Bauteile 4 und 5 und die auf den Sensor 5 ausgerichtete gewählte Polarität des Magneten ergibt sich ein charakteristisches, in Feldrichtung und Feldgröße exakt definiertes Magnetfeld. Die sich hierbei einstellenden magnetischen Feldlinien 6 zwischen magnetischem Geber 4 und Sensor 5 sind stark vereinfacht in Fig. 2 dargestellt. Der Sensor 5 überwacht das Magnetfeld hinsichtlich Feldrichtung und Feldstärke. Ein Basis- bzw. Sollwert des Sensors 5 lässt sich durch die Konfiguration bzw. Anordnung und Ausrichtung des magnetischen Gebers 4 und Sensors 5 exakt einstellen.

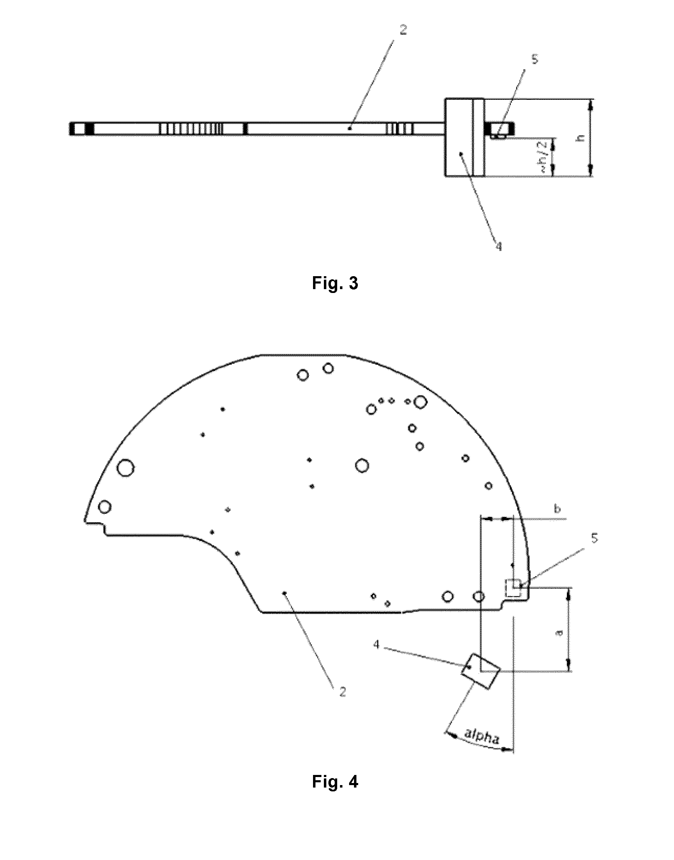

Die Ausrichtung des magnetischen Gebers 4 relativ zum Sensor 5 ist im Detail in Fig. 4 dargestellt. Diese zeigt in einer Draufsicht, in welchem Winkel der Geber 4 in der Messvorrichtung 1 und der Sensor 5 im Kommunikationsmodul 2 zueinander ausgerichtet sind. Der Abstand zwischen Geber 4 und Sensor 5 in der Horizontalen ist in Fig. 4 mit a bezeichnet und beträgt vorzugsweise 10,65 mm. Der sich durch die runde Bauform der Messeinrichtung 1 ergebende radiale Versatz zwischen Geber 4 und Sensor 5 ist in Fig. 4 mit b bezeichnet und beträgt vorzugsweise 4,2 mm. Der Geber 4 ist in der Fig. 4 leicht gedreht und weist mit der Seite, die in Fig. 2 als "Nord" (Nordpol) gekennzeichnet ist, in Richtung des Sensors 5. Die durch den Geber 4 entlang der Richtung "Nord-Süd" verlaufende Achse (vgl. Fig. 3) verläuft in einem mit "alpha" bezeichneten Winkel von 30° zu der in Fig. 3 dargestellten Anregungsrichtung des Sensors 5. In Fig. 3 ist als h die Höhe des Gebers 4 dargestellt. Mit h/2 ist die relative Position des Sensors 5 zum Geber in der Vertikalen bezeichnet. h/2 beträgt vorzugsweise 4,95 mm.

Der Sensor 5 misst das vom magnetischen Geber 4 erzeugte Magnetfeld bzw. die magnetische Flussdichte und gibt das Signal an eine nicht dargestellte Auswerteeinheit weiter, wobei eine Bewertung der magentischen Feldrichtung und der Polarität erfolgt, was eine höhere Sicherheit gegenüber Manipulationsversuchen gewährleistet.

In der Auswerteeinheit des Kommunikationsmoduls 2 sind Schwellenwerte für die magnetische Flussdichte abgelegt. Innerhalb eines festgelegten Toleranzbereichs sind gewisse Verschiebungen zwischen dem Sensor 5 und dem magnetischen Geber 4 möglich. Dadurch wird gewährleistet, dass kein Fehlalarm ausgelöst wird. Geringe Toleranzen ergeben sich bereits aufgrund von Fertigungstoleranzen, so dass eine untere Schwelle entsprechend sinnvoll gewählt ist. Die im Kommunikationsmodul 2 einstellbaren Schwellenwerte zur Erkennung einer unberechtigten Demontage werden dabei beispielsweise durch Auswahl eines geeigneten magnetoresistiven Sensors unter Verwendung der Datenblattangaben des Herstellers festgelegt.

Innerhalb der Schwellenwerte wird durch die Auswerteeinheit, bzw. das Kommunikationsmodul 2 der Zustand "montiert" erkannt. Das bedeutet im gleichen Zuge, dass die Flussdichte im Sensor 5 für den Normalbetrieb ("montiert") eine gewisse untere Schwelle überschreiten muss. Eine zu niedrige Flussdichte kann beispielsweise auch durch die falsche Orientierung des Gebermagneten 4 hervorgerufen werden. Stellt nun der Sensor 5 kein der Konfiguration entsprechend geartetes Magnetfeld fest, werden also die Schwellenwerte überschritten, so wird der Zustand "Demontage" gemeldet. Wird beispielsweise der obere Schwellenwert der Flussdichte überschritten, so wird ein Alarm an eine nicht dargestellte Datenerfassungseinrichtung gesendet und es erfolgt eine Alarmmeldung. Über einen Algorithmus in einem nicht dargestellten Mikroprozessor des Kommunikationsmoduls 2 kann die Plausibilität der Demontageerkennung geprüft und gemeldet werden.

Insgesamt bietet die Vorrichtung eine kostengünstige und sichere Möglichkeit eine Manipulation, insbesondere eine unerlaubte Demontage bei einem Verbrauchserfassungsgerät, z.B. die Demontage eines Kommunikationsmoduls von einer Messvorrichtung, insbesondere eines Wasserzählers, sicher zu erkennen und an eine Alarmstelle zu melden oder einen Alarm an einer hierzu geeigneten Vorrichtung anzuzeigen.

### Bezugszeichenliste:

- 1: Messeinrichtung
- 2: Kommunikationsmodul
- 3: Aufnahme
- 4: magnetischer Geber
- 5: Sensor
- 6: magnetische Feldlinie
- 7: Anregungsrichtung
- 8: Nordpol des magnetischen Gebers
- 9: Nordpol-Südpol-Achse des magnetischen Gebers

## Patentansprüche

1. Vorrichtung zur Erkennung von Manipulationen an einem Verbrauchserfassungsgerät mit einer Messeinrichtung (1) und wenigstens einem an dem Verbrauchserfassungsgerät angeordneten Kommunikationsmodul (2) zur Verarbeitung der von der Messeinrichtung (1) gemessenen Verbrauchsdaten, wobei die Vorrichtung einen magnetischen Geber (4) zur Erzeugung eines Magnetfeldes, einen Sensor (5) zur Erfassung des vom magnetischen Geber (4) erzeugten Magnetfeldes und eine Auswerteeinheit zur Verarbeitung der von dem Sensor (4) erzeugten Signale und zur Anzeige einer Relativbewegung zwischen Kommunikationsmodul (2) und der Messeinrichtung (1) aufweist, **dadurch gekennzeichnet, dass** der Sensor (5) derart ausgebildet ist, dass er die Feldrichtung und Feldstärke des Magnetfeldes überwacht.

2. Vorrichtung nach Anspruch 1, **dadurch gekennzeichnet, dass** der Nordpol (8) des magnetischen Gebers (4) zum Sensor (5) ausgerichtet ist, und dass relative Winkellage des magnetischen Gebers (4) zum Sensor (5) 25 bis 35° beträgt.

3. Vorrichtung nach Anspruch 1, **dadurch gekennzeichnet, dass** der Nordpol (8) des magnetischen Gebers (4) zum Sensor (5) ausgerichtet ist, und dass relative Winkellage des magnetischen Gebers (4) zum Sensor (5) -5° bis +5° beträgt.

4. Vorrichtung nach einem der vorhergehenden Ansprüche, **dadurch gekennzeichnet, dass** die Auswerteeinheit derart ausgebildet ist, dass ein Alarm an eine Datenerfassungseinrichtung gesendet wird und/oder eine Alarmanzeige erfolgt, wenn der vom Sensor erfasste Wert des Magnetfeldes vorgegebene Schwellenwerte unterschreitet und/oder überschreitet.

5. Vorrichtung nach einem der vorhergehenden Ansprüche, **dadurch gekennzeichnet, dass** der magnetische Geber (4) ein Stabmagnet ist.

6. Vorrichtung nach einem der Ansprüche 1 bis 4, **dadurch gekennzeichnet, dass** der magnetische Geber (4) eine Magnetfolie ist.

7. Vorrichtung nach einem der vorhergehenden Ansprüche, **dadurch gekennzeichnet, dass** der magnetische Geber (4) als Teil eines Gehäuses der Messeinrichtung (1) ausgebildet ist

8. Vorrichtung nach einem der vorhergehenden Ansprüche, **dadurch gekennzeichnet, dass** der Sensor (5) ein magnetoresistiver Sensor, ein Hallsensor oder ein Magnetfeldsensor ist.

9. Vorrichtung nach Anspruch 4, **dadurch gekennzeichnet dass** die Auswerteinheit derart ausgebildet ist, dass eine Alarmauslösung für eine vordefinierte Zeitspanne durch Parametrierung ausgeschaltet werden kann.

10. Verbrauchserfassungsgerät mit einer Vorrichtung zur Erkennung von Manipulationen nach einem der vorhergehenden Ansprüche.
